# EUROPEAN PATENT APPLICATION

(11) **EP 4 769 411 A1**
(43) Date of publication of application: **01.07.2026**
(21) Application number: 25219887.4
(22) Date of filing: 01.12.2025
(51) Int. Cl.: G11C 23/00, G11C 7/10, G06N 3/065, G11C 11/22, G11C 11/54, G11C 11/56, G11C 13/00, H10N 30/20

(54) **MEMS DEVICE WITH DISTRIBUTED PROGRAMMABLE ELEMENTS**

(30) Priority: 25.12.2024 US 202419001413
(71) Applicant: HONEYWELL INTERNATIONAL INC., Charlotte, NC 28202 (US)
(72) Inventor: GUND, Ved, Charlotte, 28202 (US)
(74) Representative: Ingrassia, Fisher & Lorenz UK Ltd.

(57) **Abstract**

Microelectromechanical systems (MEMS) and related devices and fabrication methods are provided for programmable memory devices configurable to support multiply-accumulate (MAC) operations. An exemplary microelectromechanical device includes readout electrodes, an intermediate electrode disposed on a deflectable structure of semiconductor material, a first set of individually programmable elements on a first portion of the deflectable structure to influence deflection of the first portion to influence a first variable capacitance between a first readout electrode and the intermediate electrode based on a programmed state of the programmable elements, and a second set of individually programmable elements on a second portion of the deflectable structure to influence deflection of the second portion to influence a second variable capacitance between a second readout electrode and the intermediate electrode based on a programmed state of the programmable elements.

## Description

### TECHNICAL FIELD

The subject matter described herein relates generally to microelectromechanical systems (MEMS), and more particularly, embodiments of the subject matter relate to MEMS devices with distributed programmable elements.

### BACKGROUND

Microelectromechanical systems (MEMS) are used in a variety of applications. In some applications, MEMS are used as part of a multiply-accumulate (MAC) component of an arithmetic logic unit (ALU), central processing unit (CPU) or other computing device for inmemory computing. However, these existing MEMS techniques are limited in terms of the number of memory levels or bit combinations that they can be programmed for, which, in turn, limits the number of bits that can be programmed or stored per unit area. Accordingly, it is desirable to provide MEMS devices capable of being programmed to improve the bit storage density. Other desirable features and characteristics will become apparent from the subsequent detailed description and the appended claims, taken in conjunction with the accompanying drawings and this background.

### BRIEF SUMMARY

Electronic devices including programmable microelectromechanical systems (MEMS) memory devices. An exemplary microelectromechanical device includes a first readout electrode, a second readout electrode, and an intermediate electrode disposed on a deflectable structure of semiconductor material. The deflectable structure includes a first portion separated from the first readout electrode by a first airgap providing a first variable capacitance between the first readout electrode and the intermediate electrode and a second portion separated from the second readout electrode by a second airgap providing a second variable capacitance between the second readout electrode and the intermediate electrode. A first plurality of individually programmable elements are disposed on the first portion of the deflectable structure, wherein the respective individually programmable elements of the first plurality of individually programmable elements include a respective programming electrode and a respective layer of programmable material disposed on the first portion between the respective programming electrode and the intermediate electrode. A second plurality of individually programmable elements is disposed on the second portion of the deflectable structure, wherein the respective individually programmable elements of the second plurality of individually programmable elements include a respective programming electrode and a respective layer of programmable material disposed on the second portion between the respective programming electrode and the intermediate electrode.

In one embodiment, a microelectromechanical device includes a first readout electrode, a second readout electrode, and a deflectable structure of semiconductor material including a first deflectable portion overlying the first readout electrode and spaced apart from the first readout electrode by a first airgap and a second deflectable portion overlying the second readout electrode and spaced apart from the second readout electrode by a second airgap. An intermediate electrode layer is disposed on the deflectable structure of semiconductor material and a plurality of individually programmable elements disposed on the deflectable structure, wherein the respective individually programmable elements include a respective programming electrode and a respective layer of programmable material disposed on the intermediate electrode layer between the respective programming electrode and the intermediate electrode layer, wherein first deflection of the first deflectable portion is influenced by a respective programmed state of the programmable material of respective individually programmable elements of a first subset of the plurality of individually programmable elements disposed on the first deflectable portion, a first variable capacitance between the first readout electrode and the intermediate electrode layer associated with the first airgap is influenced by the first deflection of the first deflectable portion, second deflection of the second deflectable portion is influenced by a respective programmed state of the programmable material of respective individually programmable elements of a second subset of the plurality of individually programmable elements disposed on the second deflectable portion, and a second variable capacitance between the second readout electrode and the intermediate electrode layer associated with the second airgap is influenced by the second deflection of the second deflectable portion.

In another embodiment, a microelectromechanical device includes a first readout electrode, a second readout electrode, a deflectable structure of semiconductor material having a first side portion spaced apart from the first readout electrode by a first airgap and a second side portion spaced apart from the second readout electrode by a second airgap, and an intermediate electrode layer disposed on the deflectable structure of semiconductor material. A first plurality of individually programmable elements is disposed on a first side of the first side portion of the deflectable structure between the deflectable structure and the first readout electrode, wherein the respective individually programmable elements of the first plurality of individually programmable elements include a respective programming electrode and a respective layer of programmable material between the respective programming electrode and the intermediate electrode on the first side of the deflectable structure. A second plurality of individually programmable elements is disposed on a second side of the second side portion of the deflectable structure between the deflectable structure and the second readout electrode, wherein the respective individually programmable elements of the second plurality of individually programmable elements include a respective programming electrode and a respective layer of programmable material between the respective programming electrode and the intermediate electrode on the second side of the deflectable structure.

This summary is provided to describe select concepts in a simplified form that are further described in the Detailed Description. This summary is not intended to identify key or essential features of the claimed subject matter, nor is it intended to be used as an aid in determining the scope of the claimed subject matter.

### BRIEF DESCRIPTION OF DRAWINGS

Exemplary embodiments of the subject matter of the present disclosure will hereinafter be described in conjunction with the following drawing figures, wherein like numerals denote like elements, and wherein:
FIG. 1 is a block diagram of an electronic device in accordance with one or more exemplary embodiments;
FIG. 2 is a schematic diagram of a programmable memory device suitable for use in the electronic device of FIG. 1 in accordance with one or more exemplary embodiments;
FIG. 3 is a top view of a programmable microelectromechanical systems (MEMS) device with out-of-plane deflection suitable for use in the programmable memory device of FIG. 2 in accordance with one or more exemplary embodiments;
FIG. 4 is a cross-sectional view of the programmable MEMS device of FIG. 3 along the line 4-4 in one or more exemplary embodiments;
FIG. 5 is a top view of a programmable microelectromechanical systems (MEMS) device with in-plane deflection suitable for use in the programmable memory device of FIG. 2 in accordance with one or more exemplary embodiments;
FIG. 6 is a cross-sectional view of the programmable MEMS device of FIG. 5 along the line 6-6 in one or more exemplary embodiments; and
FIG. 7 is a cross-sectional view of a programmable MEMS device with a combination of in-plane deflection and out-of-plane programming in one or more exemplary embodiments.

### DETAILED DESCRIPTION

The following detailed description is merely exemplary in nature and is not intended to limit the subject matter of the application and uses thereof. Furthermore, there is no intention to be bound by any expressed or implied theory presented in the preceding technical field, background, brief summary, or the following detailed description.

Embodiments of the subject matter described herein relate to microelectromechanical systems (MEMS) and related devices that include distributed individually programmable elements for improved bit storage density. An exemplary microelectromechanical device includes a deflectable structure with deflectable portions having disposed thereon respective sets of discrete individually programmable elements distributed along a respective deflectable portion. The individual programmable elements include a respective programming electrode and a respective layer of programmable material disposed on the respective deflectable portion between the respective programming electrode and an intermediate (or common) electrode disposed on the deflectable structure. The respective deflectable portions are separated from respective readout electrodes by respective airgaps that provide respective variable capacitances between the intermediate electrode and a respective readout electrode. In this regard, by providing multiple individually programmable elements distributed across a respective deflectable portion allows for the variable capacitance associated with the respective deflectable portion to be programmed, tuned or otherwise controlled with a greater amount of granularity, which, in turn, allows for the bit storage density of the microelectromechanical device to be improved by increasing the effective number of bits per unit area or distance.

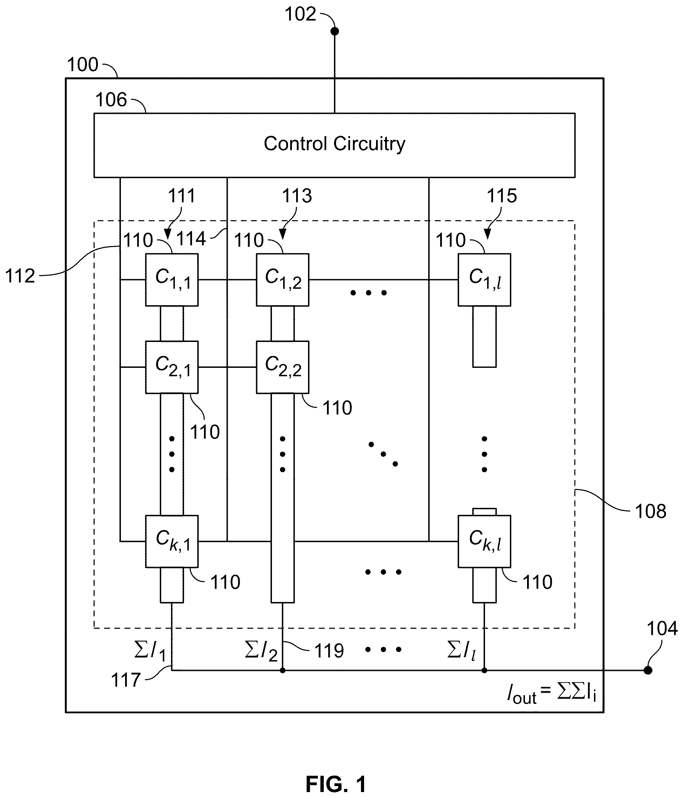

FIG. 1 depicts an exemplary embodiment of an electronic device 100 suitable for use as an arithmetic logic unit (ALU) of a processor or other computing device. In this regard, the electronic device 100 includes an input 102 for receiving an input signal indicative of one or more values to be multiplied and accumulated into an output signal at an output 104 that represents an accumulated value of the values multiplied by the electronic device 100. Accordingly, for purposes of explanation, the electronic device 100 may alternatively be referred to herein as an ALU. It should be appreciated that FIG. 1 is a simplified representation of an electronic device 100 for purposes of explanation and is not intended to be limiting.

The input 102 generally represents one or more terminals, pins, ports, or other hardware providing one or more corresponding input nodes associated with the ALU 100 that are coupled to control circuitry 106, which generally represents the hardware, firmware, software, logic and/or other components of the ALU 100 that are configured to convert the input signal indicative of an input multiplicand value to corresponding input voltage signals to be applied to respective programmable memory devices 110 of a crossbar array 108 of programmable memory devices 110. In this regard, the programmable memory devices 110 of the array 108 are individually programmable to store or otherwise maintain values for one or more multipliers to be multiplied with an input multiplicand value corresponding to the input signal received at the input 102 to arrive at a respective product that is accumulated into an accumulated output signal at the output 104 that is indicative of the result of a multiply-accumulate (MAC) operation. In this regard, the output 104 generally represents one or more terminals, pins, ports, or other hardware associated with the ALU 100 that is capable of transmitting or otherwise providing an analog signal having a signal characteristic (e.g., electrical current) that is correlative to or otherwise represents the resulting value of the MAC operation across the array 108.

In the illustrated embodiment, the programmable memory device array 108 includes a plurality of different columns 111, 113, 115 (e.g., *l* number of columns of *k* number of programmable memory devices), where each column corresponds to a respective subset of programmable memory devices 110 having a respective input coupled to the control circuitry 106 to receive an input voltage from the control circuitry 106 indicative of a value to be multiplied by a stored value maintained at the respective programmable memory device 110 of the respective column 111, 113, 115. For example, as shown, a first column 111 of the programmable memory device array 108 includes a respective subset of programmable memory devices 110 having their respective inputs coupled to a node 112, where the node 112 is coupled to or otherwise corresponds to an output of the control circuitry 106 for receiving a voltage signal indicative of an input multiplicand value to be multiplied by the respective column 111 of the programmable memory device array 108. Similarly, a second column 113 of the programmable memory device array 108 includes a respective subset of programmable memory devices 110 having their respective inputs coupled to a common node 114, where the common node 114 is coupled to or otherwise corresponds to an output of the control circuitry 106 for receiving a voltage signal indicative of an input multiplicand value to be multiplied by the respective column 113 of the programmable memory device array 108. In this regard, depending on the implementation, the respective voltage signals or input multiplicand values provided to the different columns 111 of the programmable memory device array 108 may be the same or different from one another.

The respective outputs of the programmable memory devices 110 of a respective column 111, 113 of the programmable memory device array 108 are coupled to one another or otherwise connected across the respective column 111, 113 to provide an accumulated output signal at the respective output node 117, 119 of respective column 111, 113 indicative of an accumulated product of the input multiplicand value and the respective stored multiplier values maintained by the respective programmable memory devices 110 of the respective column 111, 113. The output nodes 117, 119 of the respective columns 111, 113 of the programmable memory device array 108 are coupled to one another or otherwise connected across the columns 111, 113 at the output 104 of the ALU 100 to provide an accumulated output signal at the output 104 having an electrical current indicative of the multiplied and accumulated values across the programmable memory device array 108. In other words, the programmable memory devices 110 generally correspond to MAC units configurable to output the product of input numbers to be multiplied received from the input 102 via the control circuitry 106, where the sum of products along a respective column 111, 113 is aggregated and output at a respective output node 117, 119, with the aggregated signal at the output 104 represents the sum of the sum of products across the array 108 of the respective MAC units of the ALU 100, where the number of bits or granularity of the resulting output is influenced by the configuration and/or structure of the programmable memory devices 110.

In exemplary implementations, each of the programmable memory devices 110 is realized as a MEMS device that includes a plurality of discrete programmable elements distributed along a deflectable structure of an elastically deformable material, where each of the programmable elements is individually programmable and individually addressable. Thus, each of the programmable memory devices 110 is capable of being programmed or configured to store or otherwise maintain a respective stored multiplier value which may be different from other ones of the programmable memory devices 110. Additionally, the stored multiplier values stored by the programmable memory devices 110 may utilize multiple bits of granularity, depending on the number, size and/or dimensions of the programmable elements and/or other physical characteristics of the programmable memory devices 110. For example, depending on the implementation, the programmable memory devices 110 may be capable of storing multiplier values with 32 bits or levels of granularity (e.g., 32-bit), 64 bits or levels of granularity (e.g., 64-bit) or more, thereby increasing the bit storage density of the programmable memory devices 110, and thereby increasing the bit storage density of the ALU 100. That said, it should be appreciated that the subject matter described herein is not limited to any particular configuration of the programmable memory devices 110 or any particular word size or bit units.

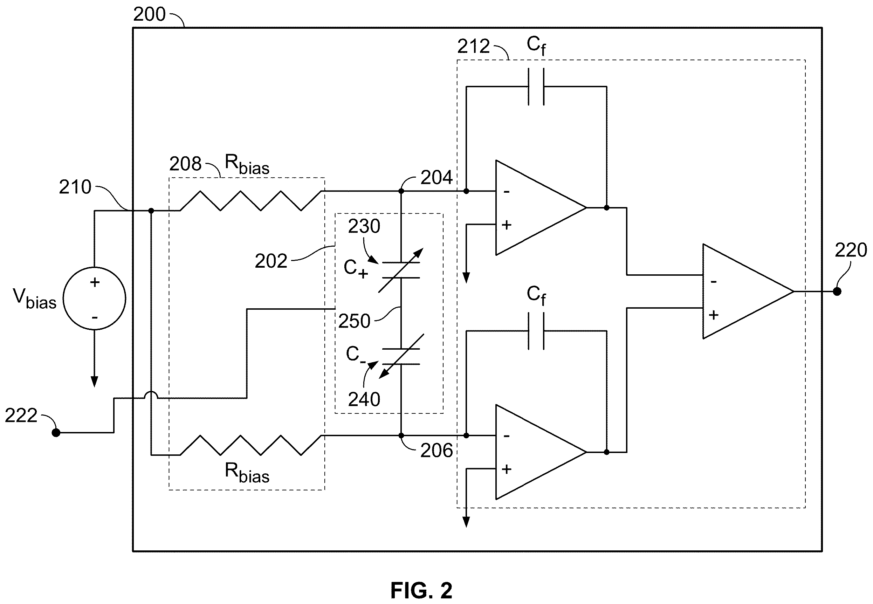

FIG. 2 depicts an exemplary embodiment of a programmable memory device 200 suitable for use as a programmable memory device 110 of the programmable memory device array 108 in the ALU 100 of FIG. 1. The programmable memory device 200 includes a microelectromechanical device 202 that includes a plurality of individually programmable elements capable of providing a programmable variable capacitance indicative of a stored multiplier value associated with the respective programmable memory device 200 to be multiplied by an input multiplicand value input to the programmable memory device 200. FIG. 2 depicts a differential implementation where the microelectromechanical device 202 provides two individually programmable variable capacitances 230, 240 electrically in series between respective nodes 204, 206 that are coupled to a node 210 for receiving a bias voltage via bias circuitry 208 configured to provide a direct current (DC) voltage bias at the nodes 204, 206 that is configured to maintain an output current flow into a differential amplifier arrangement 212 coupled to an output node 220. The microelectromechanical device 202 includes one or more control input nodes 222 that are coupled to a corresponding output of control circuitry (e.g., node 112 of control circuitry 106) for receiving a voltage signal indicative of the input multiplicand value to be multiplied by the stored multiplier value that is encoded or otherwise represented by the variable capacitances 230, 240. In this regard, the combined variable capacitance influences the respective voltage signals at the nodes 204, 206, which, in turn, are coupled to the differential amplifier arrangement 212 that generates or otherwise provides an output signal at the output node 220 (e.g., output node 117) having an electrical current or other signal characteristic indicative of the product of the input multiplicand value and the stored multiplier value.

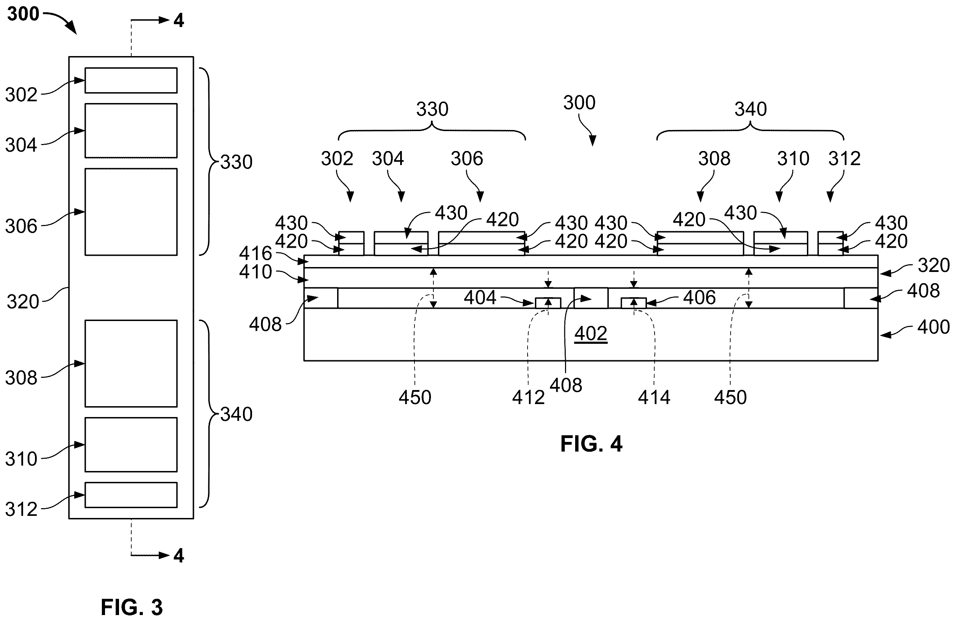

FIGS. 3-4 depict a programmable MEMS device 300 suitable for use as the microelectromechanical device 202 in a programmable memory device 110, 200 in the programmable memory device array 108 of a ALU 100 in accordance with one or more exemplary embodiments. The programmable MEMS device 300 includes a plurality of individually programmable elements 302, 304, 306, 308, 310, 312 distributed along the length of a deflectable structure 320 that includes distinct portions 330, 340 capable of out-of-plane deflection (e.g., in a direction 450 normal to a plane of the deflectable structure 320). The deflectable structure 320 includes a first deflectable portion 330 having a first subset of the programmable elements 302, 304, 306 disposed thereon to provide a first variable capacitance (e.g., variable capacitance 230) and a second deflectable portion 340 having a second subset of the programmable elements 308, 310, 312 disposed thereon to provide a second variable capacitance (e.g., variable capacitance 240), with the variable capacitances in combination defining the stored multiplier value maintained by the programmable MEMS device 300.

Referring to FIG. 4, with continued reference to FIGS. 1-3, in exemplary implementations, the programmable MEMS device 300 is formed or otherwise fabricated on a substrate 400 of semiconductor material 402, such as silicon or other bulk or handle semiconductor material. For example, the substrate 400 may be realized as a bulk silicon substrate having a thickness in the range of about 300 microns or more to provide a substantially rigid base for the MEMS device 300. A layer of rigid anchor material 408, such as silicon dioxide, silicon nitride or the like, is fabricated on or overlying the substrate semiconductor material 402 to a thickness in the range of about 200 nanometers (nm) to about 300 nm and patterned or etched to provide anchor portions that structurally support the deflectable structure 320 to maintain the deflectable portions 330, 340 elevated relative to the substrate semiconductor material 402 by respective air gaps. In this regard, the anchor material 408 may be patterned and etched to define voided regions between the respective ends of the deflectable structure 320 and a midpoint of the deflectable structure 320 that allow for deflection of the interior of the deflectable portions 330, 340.

Within the voided regions, respective electrode regions 404, 406 of a conductive material, such as aluminum, platinum, molybdenum or another suitable metal material, are formed on or overlying the substrate semiconductor material 402 to provide respective readout nodes (e.g., nodes 204, 206) for coupling the respective variable capacitances to external circuitry. In this regard, in the differential implementation of FIG. 2, a first readout electrode region 404 underlying the first deflectable portion 330 is coupled to or otherwise electrically connected to the first node 204 of the programmable memory device 200 and a second readout electrode region 406 is coupled to or otherwise electrically connected to a second node 206 of the programmable memory device 200. In exemplary implementations, the layer of conductive material for the electrode regions 404, 406 is formed to a height or thickness that is less than a height or thickness of the anchor material 408 by an amount that ensures respective airgaps 412, 414 are maintained between an upper surface of a respective electrode region 404, 406 and a lower surface of an overlying layer of deflectable material 410 of the deflectable structure 320. For example, in one or more implementations, the layer of conductive material for the electrode regions 404, 406 is formed to a thickness in the range of about 20 nm to about 30 nm (or roughly one tenth of the thickness of the layer of anchor material 408).

The layer of deflectable material 410 is realized as an elastically deformable material, such as silicon, silicon dioxide, silicon nitride or the like that is formed on the remaining portions of the anchor material 408 overlying the semiconductor substrate 400. In exemplary implementations, the layer of deflectable material 410 is different from the anchor material 408 and formed to a thickness in the range of about 100 nm to about 200 nm. In some implementations, the thickness of the deflectable material 410 is less than twice the thickness of an overlying layer of programmable material 420. In this regard, the thickness of the layer of deflectable material 410 is configured to allow the untethered deflectable portions 330, 340 to bend, deflect or otherwise deform to vary the separation distance defined by the respective airgaps 412, 414 between the readout electrode regions 404, 406 and the overlying programmable elements 302, 304, 306, 308, 310, 312, and thereby vary the variable capacitance 230, 240 associated with a respective deflectable portion 330, 340, as described in greater detail below.

In exemplary implementations, a layer of conductive material 416 is formed on or overlying the layer of deflectable material 410 to provide an intermediate electrode region that provides an electrical connection between the variable capacitances (e.g., intermediate node 250). For example, a layer of metal material, such as aluminum, platinum, molybdenum or another suitable metal material, may be conformably deposited on the upper surface of the layer of deflectable material 410 to a thickness in the range of about 20 nm to about 30 nm to avoid inhibiting deflection of the deflectable portions 330, 340 of the underlying deformable material 410.

Still referring to FIG. 4, in exemplary implementations, the programmable elements 302, 304, 306, 308, 310, 312 are fabricated or otherwise formed on the semiconductor substrate 400 by forming a layer of a programmable material 420 on or overlying an exposed upper surface of the layer of conductive material 416, forming a layer of a conductive material 430 on or overlying the surface of the layer of programmable material 420, and then patterning and etching the respective layers of materials 420, 430 overlying the intermediate common electrode layer of conductive material 416 to define distinct standalone structures that are laterally spaced apart from one another to provide distinct individually programmable elements 302, 304, 306, 308, 310, 312. For example, in one implementation, the layer of programmable material 420 is realized as a programmable ferroelectric material, such as hafnium zirconium oxide (HZO) or scandium aluminum nitride (ScAIN), that is conformably deposited or grown on the surface of the intermediate common electrode layer to a thickness in the range of about 20 nm to about 100 nm. As another example, in other implementations, the layer of programmable material 420 is realized as a programmable phase change material, such as germanium-antimony-telluride (GST), that is formed to a thickness in the range of about 50 nm to about 100 nm.

After forming the programmable material 420, the layer of conductive material 430 is formed by conformably depositing a layer of metal material, such as aluminum, platinum, molybdenum or another suitable metal material, to a thickness in the range of about 20 nm to about 30 nm. Thereafter, a layer of masking material (e.g., photoresist, a polymer material, silicon nitride, or the like) is formed overlying the semiconductor substrate 400 and patterned to define an etch mask for etching or otherwise removing unmasked portions of the programmable material 420 and conductive material 430 to define the laterally distinct programmable elements 302, 304, 306, 308, 310, 312 of programmable material 420 overlying the intermediate common electrode layer of conductive material 416.

The remaining conductive material 430 of the programmable elements 302, 304, 306, 308, 310, 312 functions as a programming electrode or control input to the respective programmable elements 302, 304, 306, 308, 310, 312 for individually addressing and individually programming the respective programmable elements 302, 304, 306, 308, 310, 312 by altering a characteristic of the programmable material 420 of the respective programmable elements 302, 304, 306, 308, 310, 312. For example, when the programmable material 420 is realized as a programmable ferroelectric material, a respective programming control voltage may be applied to the respective programming electrode material 430 for a respective programming duration configured to alter, adjust or otherwise change the electric polarization of the ferroelectric material by an amount that produces a corresponding change in the Young's modulus of the programmable material 420 in a manner that corresponds to the respective bit word corresponding to the multiplier value to be stored at the respective programmable element 302, 304, 306, 308, 310, 312. Alternatively, when the programmable material 420 is realized as a programmable phase change material, a respective programming voltage may be applied to the respective programming electrode material 430 for a respective programming duration configured to alter, adjust or otherwise change the volume of the phase change material by an amount that produces a corresponding change in the density, and thereby, the Young's modulus of the programmable material 420 in a manner that corresponds to the respective bit word corresponding to the multiplier value to be stored at the respective programmable element 302, 304, 306, 308, 310, 312.

In exemplary implementations, the programming electrode material 430 of each programmable element 302, 304, 306, 308, 310, 312 is coupled to control circuitry (e.g., node 112 of control circuitry 106 via a control input node 222) that is configured to receive input indicative of a desired multiplier value to be stored or otherwise maintained by a respective programmable MEMS device 300 and determine a corresponding manner for programming the respective programmable elements 302, 304, 306, 308, 310, 312 by applying a programming control voltage to the respective programming electrode material 430 of each respective programmable element 302, 304, 306, 308, 310, 312 for a respective programming duration of time that is configurable to cause the programmable material 420 to alter its characteristics in a manner that corresponds to a particular bit word (or combination of bits) to be stored by the respective programmable element 302, 304, 306, 308, 310, 312.

After individually programming the respective programmable elements 302, 304, 306, 308, 310, 312 to store or otherwise maintain the desired multiplier value, the control circuitry may input or otherwise provide an applied voltage signal corresponding to an input multiplicand value at the respective electrodes 430 of the programmable elements 302, 304, 306, 308, 310, 312 (e.g., the input voltage signal applied from control circuitry output node 112 to one or more control input nodes 222). The applied voltage to the electrode material 430 results in respective voltage differences (and corresponding electric fields) across the programmable material 420 that results in a force that causes the deflectable portions 330, 340 to deflect towards and/or away from the substrate 400 in a manner that is influenced by the Young's modulus of the respective programmable element 302, 304, 306, 308, 310, 312. In this regard, the programmed characteristic of the programmable elements 302, 304, 306, 308, 310, 312 influences the deflection of the deflectable portions 330, 340 to vary the separation distance of the respective airgaps 412, 414 and thereby control the variable capacitances 230, 240 between the intermediate electrode node 250, 416 and the respective readout nodes 204, 206, 404, 406 in a manner that corresponds to the programmed multiplier value stored by the MEMS device 300. It will be appreciated that one or more characteristics of the applied voltage for the input multiplicand value (e.g., the magnitude, duration, frequency, etc.) is different from the programming voltage indicative of the stored multiplier value such that the subsequently applied voltage does not influence the programmed characteristic of the programmable elements 302, 304, 306, 308, 310, 312.

For example, an applied voltage may cause the first deflectable portion 330 to bend or deflect out-of-plane towards the readout electrode 404 (e.g., in a direction perpendicular to a plane of the layer of programmable material 420) based on the programmed characteristics of the programmable elements 302, 304, 306 associated with the first deflectable portion 330 in a manner that reduces the capacitance 230 while causing the second deflectable portion 340 to bend or deflect out-of-plane away from the readout electrode 406 based on the programmed characteristics of the programmable elements 308, 310, 312 associated with the second deflectable portion 340 in a manner that reduces the capacitance 240. In this regard, the cumulative aggregate deflection of the deflectable portions 330, 340 corresponds to product of the input value represented by the applied voltage and the stored multiplier value corresponding to the capacitances 230, 240. Thus, by virtue of the programmed variable capacitances 230, 240 resulting from the programmed state of the programmable elements 302, 304, 306, 308, 310, 312, the relationship of the electrical current at the readout electrodes 404, 406 coupled to the input nodes 204, 206 to the differential amplifier arrangement 212 varies with respect to the input voltage signal applied to the input (or programming) electrodes 430 in a manner that reflects the product of the applied input multiplicand value at the control input node(s) 222 and the stored multiplier value corresponding to the programmed variable capacitances 230, 240, resulting in an output signal at the output node 220 having an electrical current corresponding to the product of the input multiplicand value and the stored multiplier value with the desired granularity.

It should be noted that FIGS. 3-4 depict an implementation where the programmable elements 302, 304, 306, 308, 310, 312 are logarithmically or nonlinearly grated or otherwise asymmetric in size or shape, such that the respective lengths of the programmable elements 302, 304, 306, 308, 310, 312 vary along the length of a respective deflectable portion 330, 340 (e.g., the cross-sectional dimension of programmable element 306 in FIG. 4 is greater than the cross-sectional dimension of programmable element 304, which is greater than the cross-sectional dimension of programmable element 302). In this regard, varying the size or dimensions across a respective subset of programmable elements 302, 304, 306, 308, 310, 312 on a respective deflectable portion 330, 340 may be utilized to tune the granularity or bits of values capable of being implemented using the respective MEMS device 300. That said, in other implementations, the programmable elements 302, 304, 306, 308, 310, 312 may be linearly grated or otherwise shaped symmetrically, such that the respective lengths of the programmable elements 302, 304, 306, 308, 310, 312 are equal to one another along the length of a respective deflectable portion 330, 340. Additionally, it should be noted that although FIGS. 3-4 depict an implementation where the lateral spacing or separation distance between adjacent programmable elements 302, 304, 306, 308, 310, 312 on a common deflectable portion 330, 340 is substantially equal or constant along the length of the deflectable portion 330, 340, in other implementations, the lateral spacing or separation distance between adjacent programmable elements 302, 304, 306, 308, 310, 312 may vary along the length of a deflectable portion 330, 340. Accordingly, the subject matter described herein is not intended to be limited to any particular number or geometric arrangement of programmable elements 302, 304, 306, 308, 310, 312.

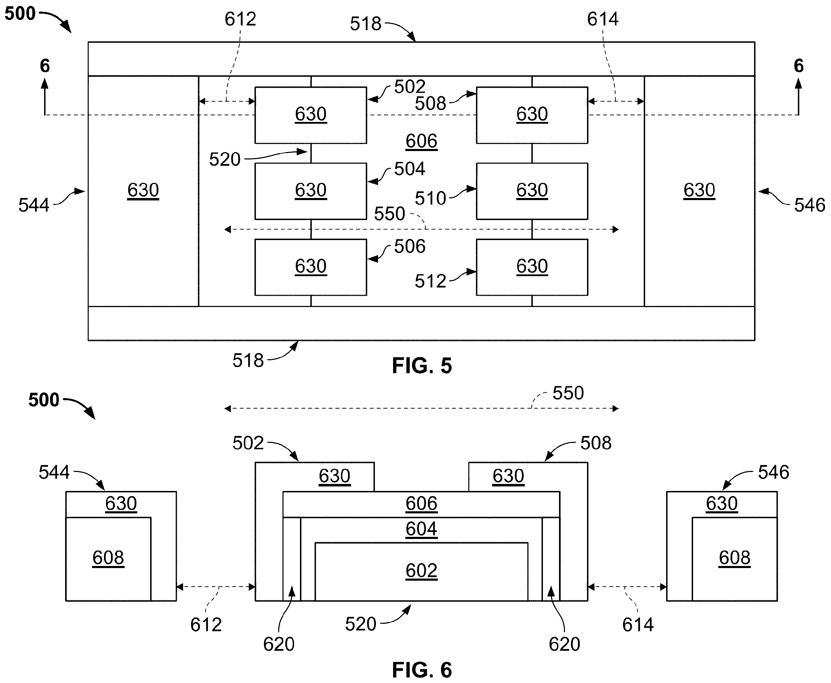

FIGS. 5-6 depict an alternative implementation of a programmable MEMS device 500 suitable for use as the microelectromechanical device 202 in a programmable memory device 110, 200 in the programmable memory device array 108 of a ALU 100 in accordance with one or more embodiments. The programmable MEMS device 500 includes a deflectable structure 520 capable of in-plane deflection (e.g., in a direction 550 parallel to a plane of the deflectable structure 520). For purposes of explanation, FIG. 5 depicts an individual deflectable portion including a plurality of individually programmable elements 502, 504, 506, 508, 510, 512 uniformly and symmetrically distributed along the length of respective sides of the deflectable structure 520 between anchor portions 518, however, in practice, the deflectable structure 520 may include multiple deflectable portions. In this regard, the deflectable structure 520 includes a first subset of the programmable elements 502, 504, 506 disposed on a first deflectable side portion of the deflectable structure 520 to provide a first variable capacitance (e.g., variable capacitance 230) and a second subset of the programmable elements 508, 510, 512 disposed on the deflectable side portion on the opposite side of the deflectable structure 520 to provide a second variable capacitance (e.g., variable capacitance 240), with the variable capacitances in combination defining the stored multiplier value maintained by the programmable MEMS device 500.

In exemplary implementations, the programmable MEMS device 500 is formed or otherwise fabricated on a substrate of semiconductor material. A layer of rigid anchor material is fabricated on or overlying the substrate semiconductor material and patterned or etched to provide anchor portions 518 that structurally retain ends of the deflectable structure 520 to maintain the deflectable portion having the programmable elements 502, 504, 506, 508, 510, 512 disposed thereon spaced apart from readout electrode portions 544, 546 of semiconductor material 608 by respective air gaps. Within the voided region defined by the anchor portions 518 and readout electrode portions 544, 546, a layer of deflectable material 602 is formed and etched to provide the deflectable structure 520 having a length that extends between the anchor portions 518 laterally in between the readout electrode portions 544, 546. In a similar manner as described above, the layer of deflectable material 602 may be realized as an elastically deformable material that is different from the anchor material and semiconductor material 608 and formed to a height or thickness that is less than a thickness or height of the surrounding portions 544, 546, 518.

A layer of a conductive material 604, such as aluminum, platinum, molybdenum or another suitable metal material, is conformably formed on or overlying the deflectable material 602 to provide an intermediate common electrode layer corresponding to the common intermediate node (e.g., node 250) between the variable capacitances. Thereafter, the programmable elements 502, 504, 506, 508, 510, 512 are fabricated or otherwise formed on by conformably forming a layer of a programmable material 620 (e.g., a programmable ferroelectric material, a phase change material, or the like) on or overlying the deflectable structure 520 and then patterning and etching the programmable material 620 to define distinct standalone structures that are longitudinally spaced apart from one another along the sidewalls of the deflectable structure 520 to provide distinct individually programmable elements 502, 504, 506, 508, 510, 512 along the respective sides of the deflectable structure 520. In this regard, in a similar manner as described above, the layer of programmable material 620 may be conformably deposited or grown on the surface of the intermediate common electrode material 604 to a thickness in the range of about 20 nm to about 100 nm before being anisotropically etched to remove the programmable material 620 from the upper surface of the electrode material 604.

Prior to forming the programmable material 620, a layer of insulating material 606, such as silicon dioxide or another suitable insulating material, is formed on the upper surfaces of the common electrode material 604 to provide electrical isolation in a vertical dimension. Thereafter, a layer of conductive material 630 is formed by conformably depositing a layer of metal material, such as aluminum, platinum, molybdenum or another suitable metal material, overlying the deflectable structure 520 and the readout electrode portions 544, 546 and then patterned or etched to provide the respective input (or programming) electrodes of the programmable elements 502, 504, 506, 508, 510, 512 along with the respective readout electrodes on the readout portions 544, 546. In this regard, in the differential implementation of FIG. 2, the conductive electrode material 630 on the first readout portion 544 is coupled to or otherwise electrically connected to the first node 204 of the programmable memory device 200 and the conductive electrode material 630 on the second readout portion 546 is coupled to or otherwise electrically connected to a second node 206 of the programmable memory device 200. In exemplary implementations, the layer of conductive electrode material 630 is formed to a thickness that is less than an amount that ensures respective airgaps 612, 614 are maintained laterally between the outer surface of the electrode material 630 of a respective programmable element 502, 504, 506, 508, 510, 512 and the inner surface of the conductive electrode material 630 of the respective readout portions 544, 546.

In a similar manner as described above in the context of FIGS. 1-4, the programming electrode material 630 of each programmable element 502, 504, 506, 508, 510, 512 is coupled to control circuitry (e.g., node 112 of control circuitry 106 via a control input node 222) that is configured to receive input indicative of a desired multiplier value to be stored or otherwise maintained by a respective programmable MEMS device 500 and determine a corresponding manner for programming the respective programmable elements 502, 504, 506, 508, 510, 512 by applying a programming control voltage to the respective programming electrode material 630 of each respective programmable element 502, 504, 506, 508, 510, 512 for a respective programming duration of time that is configurable to cause the programmable material 620 to alter its characteristics in a manner that corresponds to a particular bit word (or combination of bits) to be stored by the respective programmable element 502, 504, 506, 508, 510, 512.

In a similar manner as described above in the context of FIGS. 1-4, after individually programming the respective programmable elements 502, 504, 506, 508, 510, 512 to store or otherwise maintain the desired multiplier value, the control circuitry may input or otherwise provide an applied voltage signal corresponding to an input multiplicand value at the respective electrodes 630 of the programmable elements 502, 504, 506, 508, 510, 512. The applied voltage to the electrode material 630 results in respective voltage differences (and corresponding electric fields) across the programmable material 620 that results in a force that causes the deflectable structure 520 to deflect laterally in-plane (indicated by direction 550) towards and/or away from the respective readout portions 544, 546 in a manner that is influenced by the Young's modulus of the respective programmable element 502, 504, 506, 508, 510, 512. In this regard, the programmed characteristic of the programmable elements 502, 504, 506, 508, 510, 512 influences the deflection of the deflectable structure 520 to vary the separation distance of the respective airgaps 612, 614 and thereby control the variable capacitances 230, 240 between the intermediate electrode node 250, 604 and the respective readout nodes 204, 206, 544, 546 in a manner that corresponds to the programmed multiplier value stored by the MEMS device 500.

It should be noted that FIGS. 5-6 depict an implementation where the programmable elements 502, 504, 506, 508, 510, 512 are linearly grated and symmetrical in shape along the length of the deflectable structure 520; however, in alternative implementations, the programmable elements 502, 504, 506, 508, 510, 512 may be logarithmically or nonlinearly grated or otherwise asymmetric in shape, such that the respective lengths of the programmable elements 502, 504, 506, 508, 510, 512 vary along the length of the deflectable structure 520 in a similar manner as depicted in FIGS. 3-4. In this regard, it should be noted that the respective lengths and/or the lateral spacing or separation distances between adjacent programmable elements 502, 504, 506, 508, 510, 512 may vary along the length of the deflectable structure 520. Accordingly, the subject matter described herein is not intended to be limited to any particular number or geometric arrangement of programmable elements 502, 504, 506, 508, 510, 512. It should be noted that in practice, a MEMS device 500 with in-plane lateral deflection may be utilized to improve manufacturability when the dimensions of the structure are lithographically defined such that variations in the thickness of the elastic layer cancel out and require less control of the programming layer thickness.

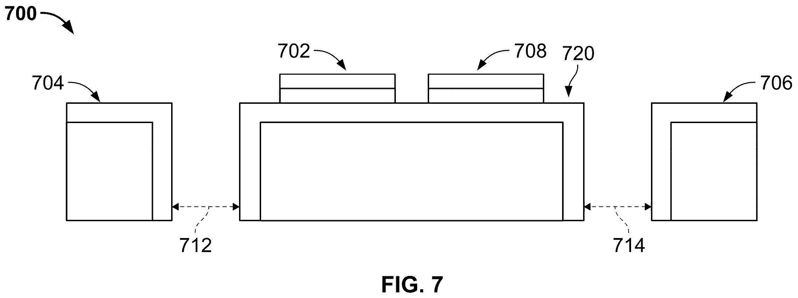

FIG. 7 depicts an alternative implementation of a programmable MEMS device 700 suitable for use as the microelectromechanical device 202 in a programmable memory device 110, 200 in the programmable memory device array 108 of a ALU 100 in accordance with one or more embodiments. Similar to the programmable MEMS device 500 of FIGS. 5-6, the programmable MEMS device 700 includes a deflectable structure 720 capable of in-plane deflection parallel to a plane of the deflectable structure 720 towards and/or away from electrode portions 704, 706 corresponding to nodes 204, 206. However, in contrast to the programmable MEMS device 500 of FIGS. 5-6, rather than being formed on sidewalls of the deflectable structure 520, in the embodiment of FIG. 7, the programmable elements 702, 708 are formed on the upper surface of the deflectable structure 720 in a similar manner as described above in the context of FIGS. 3-4. In this regard, the programmable elements 702, 708 are programmed to alter a polarization, volume or other characteristic in an out-of-plane dimension, similar to the programmable MEMS device 300 of FIG. 3-4, but the programmable elements 702, 708 are programmed in a manner relative to one another that causes the deflectable structure 720 to bend, twist or otherwise deflect in-plane to vary the separation distances of the respective airgaps 712, 714 between the deflectable structure 720 and the readout electrode portions 704, 706 to vary the capacitance between the readout nodes 204, 206 of the programmable memory device 110, 200.

For the sake of brevity, conventional techniques related to MEMS devices and fabrication, semiconductor fabrication, MAC operations, ALUs, computing devices, and other functional aspects of the systems (and the individual operating components of the systems) may not be described in detail herein. Furthermore, the connecting lines shown in the various figures contained herein are intended to represent exemplary functional relationships and/or physical couplings between the various elements. It should be noted that many alternative or additional functional relationships or physical connections may be present in an embodiment of the subject matter.

As used herein, the word "exemplary" means "serving as an example, instance, or illustration." Thus, any embodiment described herein as "exemplary" is not necessarily to be construed as preferred or advantageous over other embodiments. All of the embodiments described herein are exemplary embodiments provided to enable persons skilled in the art to make or use the invention and not to limit the scope of the invention which is defined by the claims.

Those of skill in the art will appreciate that the various illustrative logical blocks, modules, circuits, and algorithm steps described in connection with the embodiments disclosed herein may be implemented as electronic hardware, computer software, or combinations of both. Some of the embodiments and implementations are described above in terms of functional and/or logical block components (or modules) and various processing steps. However, it should be appreciated that such block components (or modules) may be realized by any number of hardware, software, and/or firmware components configured to perform the specified functions. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present invention. For example, an embodiment of a system or a component may employ various integrated circuit components, e.g., memory elements, digital signal processing elements, logic elements, look-up tables, or the like, which may carry out a variety of functions under the control of one or more microprocessors or other control devices. In addition, those skilled in the art will appreciate that embodiments described herein are merely exemplary implementations.

The various illustrative logical blocks, modules, and circuits described in connection with the embodiments disclosed herein may be implemented or performed with a general purpose processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general-purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

The steps of a method or algorithm described in connection with the embodiments disclosed herein may be embodied directly in hardware, in a software module executed by a processor, or in a combination of the two. A software module may reside in RAM memory, flash memory, ROM memory, EPROM memory, EEPROM memory, registers, hard disk, a removable disk, a CD-ROM, or any other form of non-transitory storage medium known in the art. An exemplary storage medium is coupled to the processor such that the processor can read information from, and write information to, the storage medium. In the alternative, the storage medium may be integral to the processor. The processor and the storage medium may reside in an ASIC.

The subject matter may be described herein in terms of functional and/or logical block components, and with reference to symbolic representations of operations, processing tasks, and functions that may be performed by various computing components or devices. Such operations, tasks, and functions are sometimes referred to as being computer-executed, computerized, software-implemented, or computer-implemented. In practice, one or more processor devices can carry out the described operations, tasks, and functions by manipulating electrical signals representing data bits at memory locations in the system memory, as well as other processing of signals. The memory locations where data bits are maintained are physical locations that have particular electrical, magnetic, optical, or organic properties corresponding to the data bits. It should be appreciated that the various block components shown in the figures may be realized by any number of hardware, software, and/or firmware components configured to perform the specified functions. For example, an embodiment of a system or a component may employ various integrated circuit components, e.g., memory elements, digital signal processing elements, logic elements, look-up tables, or the like, which may carry out a variety of functions under the control of one or more microprocessors or other control devices.

When implemented in software or firmware, various elements of the systems described herein are essentially the code segments or instructions that perform the various tasks. The program or code segments can be stored in a processor-readable medium or transmitted by a computer data signal embodied in a carrier wave over a transmission medium or communication path. The "computer-readable medium", "processor-readable medium", or "machine-readable medium" may include any medium that can store or transfer information. Examples of the processor-readable medium include an electronic circuit, a semiconductor memory device, a ROM, a flash memory, an erasable ROM (EROM), a floppy diskette, a CD-ROM, an optical disk, a hard disk, a fiber optic medium, a radio frequency (RF) link, or the like. The computer data signal may include any signal that can propagate over a transmission medium such as electronic network channels, optical fibers, air, electromagnetic paths, or RF links. The code segments may be downloaded via computer networks such as the Internet, an intranet, a LAN, or the like.

Some of the functional units described in this specification have been referred to as "modules" in order to more particularly emphasize their implementation independence. For example, functionality referred to herein as a module may be implemented wholly, or partially, as a hardware circuit comprising custom VLSI circuits or gate arrays, off-the-shelf semiconductors such as logic chips, transistors, or other discrete components. A module may also be implemented in programmable hardware devices such as field programmable gate arrays, programmable array logic, programmable logic devices, or the like. Modules may also be implemented in software for execution by various types of processors. An identified module of executable code may, for instance, comprise one or more physical or logical modules of computer instructions that may, for instance, be organized as an object, procedure, or function. Nevertheless, the executables of an identified module need not be physically located together, but may comprise disparate instructions stored in different locations that, when joined logically together, comprise the module and achieve the stated purpose for the module. Indeed, a module of executable code may be a single instruction, or many instructions, and may even be distributed over several different code segments, among different programs, and across several memory devices. Similarly, operational data may be embodied in any suitable form and organized within any suitable type of data structure. The operational data may be collected as a single data set, or may be distributed over different locations including over different storage devices, and may exist, at least partially, merely as electronic signals on a system or network.

In this document, relational terms such as first and second, and the like may be used solely to distinguish one entity or action from another entity or action without necessarily requiring or implying any actual such relationship or order between such entities or actions. Numerical ordinals such as "first," "second," "third," etc. simply denote different singles of a plurality and do not imply any order or sequence unless specifically defined by the claim language. The sequence of the text in any of the claims does not imply that process steps must be performed in a temporal or logical order according to such sequence unless it is specifically defined by the language of the claim. The process steps may be interchanged in any order without departing from the scope of the invention as long as such an interchange does not contradict the claim language and is logically coherent.

Furthermore, the foregoing description may refer to elements or nodes or features being "coupled" together. As used herein, unless expressly stated otherwise, "coupled" means that one element/node/feature is directly or indirectly joined to (or directly or indirectly communicates with) another element/node/feature, and not necessarily mechanically. For example, two elements may be coupled to each other physically, electronically, logically, or in any other manner, through one or more additional elements. Thus, although the drawings may depict one exemplary arrangement of elements directly connected to one another, additional intervening elements, devices, features, or components may be present in an embodiment of the depicted subject matter. In addition, certain terminology may also be used herein for the purpose of reference only, and thus are not intended to be limiting.

While at least one exemplary embodiment has been presented in the foregoing detailed description of the invention, it should be appreciated that a vast number of variations exist. It should also be appreciated that the exemplary embodiment or exemplary embodiments are only examples, and are not intended to limit the scope, applicability, or configuration of the invention in any way. Rather, the foregoing detailed description will provide those skilled in the art with a convenient road map for implementing an exemplary embodiment of the invention. It being understood that various changes may be made in the function and arrangement of elements described in an exemplary embodiment without departing from the scope of the invention as set forth in the appended claims.

## Claims

1. A microelectromechanical device comprising:
a first readout electrode;
a second readout electrode;
an intermediate electrode disposed on a deflectable structure of semiconductor material, the deflectable structure comprising:
a first portion separated from the first readout electrode by a first airgap providing a first variable capacitance between the first readout electrode and the intermediate electrode; and
a second portion separated from the second readout electrode by a second airgap providing a second variable capacitance between the second readout electrode and the intermediate electrode;
a first plurality of individually programmable elements disposed on the first portion of the deflectable structure, wherein the respective individually programmable elements of the first plurality of individually programmable elements comprise a respective programming electrode and a respective layer of programmable material disposed on the first portion between the respective programming electrode and the intermediate electrode; and
a second plurality of individually programmable elements disposed on the second portion of the deflectable structure, wherein the respective individually programmable elements of the second plurality of individually programmable elements comprise a respective programming electrode and a respective layer of programmable material disposed on the second portion between the respective programming electrode and the intermediate electrode.

2. The microelectromechanical device of claim 1, wherein the programmable material comprises a programmable ferroelectric material.

3. The microelectromechanical device of claim 1, wherein the programmable material comprises a phase change material.

4. The microelectromechanical device of claim 1, wherein the first plurality of individually programmable elements are disposed overlying the first portion of the deflectable structure and configurable to deflect the first portion of the deflectable structure in an out-of-plane direction perpendicular to a plane of the respective layer of programmable material.

5. The microelectromechanical device of claim 4, wherein the second plurality of individually programmable elements are disposed overlying the second portion of the deflectable structure and configurable to deflect the second portion of the deflectable structure in the out-of-plane direction.

6. The microelectromechanical device of claim 5, wherein:
the intermediate electrode comprises a layer of conductive material disposed on an upper surface of the deflectable structure;
the first plurality of individually programmable elements are disposed on the layer of conductive material within a first deflectable portion of the deflectable structure; and
the second plurality of individually programmable elements are disposed on the layer of conductive material within a second deflectable portion of the deflectable structure.

7. The microelectromechanical device of claim 1, wherein the first plurality of individually programmable elements are disposed on a side surface of the first portion of the deflectable structure and configurable to deflect the first portion of the deflectable structure in an in-plane direction perpendicular to a plane of the respective layer of programmable material.

8. The microelectromechanical device of claim 7, wherein the second plurality of individually programmable elements are disposed on a second side surface of the second portion of the deflectable structure opposite the first plurality of individually programmable elements and configurable to deflect the second portion of the deflectable structure in the in-plane direction.

9. The microelectromechanical device of claim 1, wherein the first plurality of individually programmable elements are disposed on an upper surface of the first portion of the deflectable structure and configurable to deflect the first portion of the deflectable structure in an in-plane direction parallel to a plane of the respective layer of programmable material.

10. The microelectromechanical device of claim 1, wherein the first plurality of individually programmable elements are individually addressable and the second plurality of individually programmable elements are individually addressable.

11. The microelectromechanical device of claim 1, wherein the individually programmable elements of the first plurality of individually programmable elements are symmetric with respect to one another.

12. The microelectromechanical device of claim 1, wherein the individually programmable elements of the first plurality of individually programmable elements are asymmetric with respect to one another.

13. The microelectromechanical device of claim 1, wherein the individually programmable elements of the first plurality of individually programmable elements are evenly distributed along a length of the first portion.

14. A microelectromechanical device comprising:
a first readout electrode;
a second readout electrode;
a deflectable structure of semiconductor material comprising:
a first deflectable portion overlying the first readout electrode and spaced apart from the first readout electrode by a first airgap; and
a second deflectable portion overlying the second readout electrode and spaced apart from the second readout electrode by a second airgap;
an intermediate electrode layer disposed on the deflectable structure of semiconductor material; and
a plurality of individually programmable elements disposed on the deflectable structure, wherein the respective individually programmable elements comprise a respective programming electrode and a respective layer of programmable material disposed on the intermediate electrode layer between the respective programming electrode and the intermediate electrode layer, wherein:
first deflection of the first deflectable portion is influenced by a respective programmed state of the programmable material of respective individually programmable elements of a first subset of the plurality of individually programmable elements disposed on the first deflectable portion;
a first variable capacitance between the first readout electrode and the intermediate electrode layer associated with the first airgap is influenced by the first deflection of the first deflectable portion;
second deflection of the second deflectable portion is influenced by a respective programmed state of the programmable material of respective individually programmable elements of a second subset of the plurality of individually programmable elements disposed on the second deflectable portion; and
a second variable capacitance between the second readout electrode and the intermediate electrode layer associated with the second airgap is influenced by the second deflection of the second deflectable portion.

15. A microelectromechanical device comprising:
a first readout electrode;
a second readout electrode;
a deflectable structure of semiconductor material comprising a first side portion spaced apart from the first readout electrode by a first airgap and a second side portion spaced apart from the second readout electrode by a second airgap;
an intermediate electrode layer disposed on the deflectable structure of semiconductor material;
a first plurality of individually programmable elements disposed on a first side of the first side portion of the deflectable structure between the deflectable structure and the first readout electrode, wherein the respective individually programmable elements of the first plurality of individually programmable elements comprise a respective programming electrode and a respective layer of programmable material between the respective programming electrode and the intermediate electrode on the first side of the deflectable structure; and
a second plurality of individually programmable elements disposed on a second side of the second side portion of the deflectable structure between the deflectable structure and the second readout electrode, wherein the respective individually programmable elements of the second plurality of individually programmable elements comprise a respective programming electrode and a respective layer of programmable material between the respective programming electrode and the intermediate electrode on the second side of the deflectable structure.
